# EUROPEAN PATENT APPLICATION

(11) **EP 4 772 891 A1**
(43) Date of publication of application: **08.07.2026**
(21) Application number: 24858267.8
(22) Date of filing: 09.08.2024
(51) Int. Cl.: G01R 31/00, G01R 19/00, B60L 53/14

(54) **ELECTRONIC LOCK DETECTION CIRCUIT, CHARGING PILE AND VEHICLE**

(30) Priority: 30.08.2023 CN 202311113889
(71) Applicant: BYD Company Limited, Shenzhen, Guangdong 518118 (CN)
(72) Inventor: HE, Jia, Shenzhen, Guangdong 518118 (CN); WEI, Yu, Shenzhen, Guangdong 518118 (CN)
(74) Representative: Mathys & Squire
(86) International application number: PCT/CN2024/110964
(87) International publication number: WO 2025/044724

(57) **Abstract**

An electronic lock detection circuit is provided, including an electronic lock and a signal conversion circuit, where the electronic lock and the signal conversion circuit are located in a same detection circuit, and the signal conversion circuit is configured to convert a collected signal of the electronic lock and then send a converted signal to a processor.

## Description

This application claims priority to Chinese patent application No. 202311113889.X, filed with the China National Intellectual Property Administration on August 30, 2023 and entitled "ELECTRONIC LOCK DETECTION CIRCUIT, CHARGING PILE, AND VEHICLE", which is incorporated herein by reference in its entirety.

### TECHNICAL FIELD

This application relates to the field of new energy vehicle technologies, and in particular, to an electronic lock detection circuit, a charging pile, and a vehicle.

### BACKGROUND

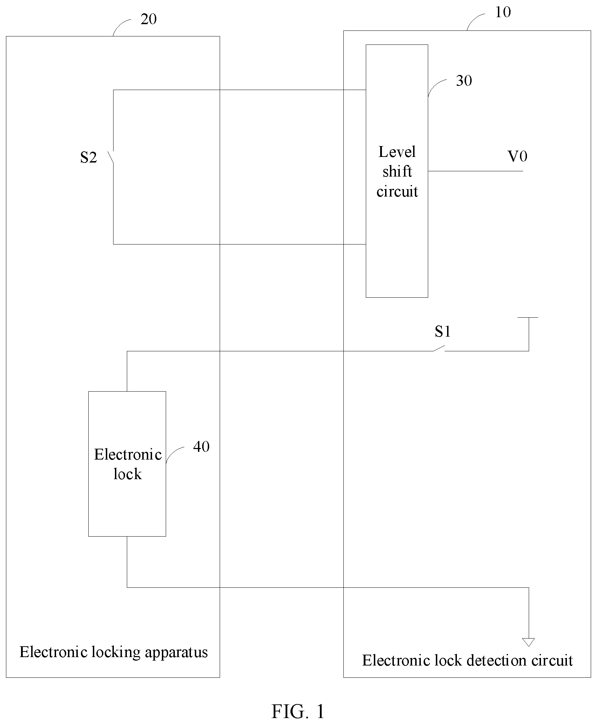

An existing electronic lock detection circuit is shown in FIG. 1. An electronic locking apparatus 20 includes an electronic lock 40 and an electronic lock feedback switch S2. The electronic lock detection circuit 10 is configured to provide a power supply for the electronic lock. The electronic lock detection circuit 10 includes a switch S1 and a level shift circuit 30, and energization or de-energization of a power supply terminal of the electronic lock is controlled by the switch S1. When the switch S1 in a power supply device or an internal controller of an electric vehicle is closed, the power supply terminal of the electronic lock is energized, making the electronic lock actuate. In addition, a coil drives an electronic lock position feedback switch S2 to actuate, and a signal from the electronic lock position feedback switch S2 is converted by the level shift circuit in the controller to generate a level signal at an output terminal Vo of the level shift circuit. The power supply device or the internal controller of the electric vehicle determines whether the electronic lock has correctly engaged a mechanical lock into a locked state or has released the mechanical lock into an unlocked state by detecting changes in high and low levels of the level signal at the Vo terminal.

### SUMMARY

An embodiment of this application provides an electronic lock detection circuit, a charging pile, and a vehicle to solve a technical problem described above.

A first aspect of the embodiment of this application provides an electronic lock detection circuit, including
an electronic lock; and
a signal conversion circuit, wherein the electronic lock and the signal conversion circuit are located in a same detection circuit, and the signal conversion circuit is configured to convert a collected signal of the electronic lock and then send a converted signal to a processor.

Optionally, the signal conversion circuit includes an amplification unit, and the amplification unit is configured to amplify the collected signal of the electronic lock and then send an amplified signal to the processor.

Optionally, the signal conversion circuit includes an isolation unit, and the isolation unit is configured to isolate the collected signal of the electronic lock and then send an isolated signal to the processor.

Optionally, the signal conversion circuit includes an amplification unit and an isolation unit. The amplification unit is configured to amplify the collected signal of the electronic lock, and the isolation unit is configured to isolate the amplified signal and then send an isolated amplified signal to the processor.

Optionally, the amplification unit includes a resistor R3, a resistor R4, and an operational amplifier U2, a first terminal of the resistor R3 is an input terminal of the signal conversion circuit, a second terminal of the resistor R3 is connected to an inverting input terminal of the operational amplifier U2 and a first terminal of the resistor R4, a second terminal of the resistor R4 is connected to an output terminal of the operational amplifier U2, a non-inverting input terminal of the operational amplifier U2 is connected to a reference bias voltage, and the output terminal of the operational amplifier U2 is an output terminal of an amplification module.

Optionally, the isolation unit includes a resistor R6, a resistor R7, a second switch, and a photocoupler U3; the resistor R6, the second switch, and a transmitting terminal of the photocoupler U3 form a first series branch; the resistor R7 and a receiving terminal of the photocoupler U3 form a second series branch; and a control terminal of the second switch is an input terminal of the isolation unit.

Optionally, the second switch is an NMOS (N-Metal-Oxide-Semiconductor) transistor Q1; a gate of the NMOS transistor Q1 is the control terminal of the second switch, a source of the NMOS transistor Q1 is grounded, and a drain of the NMOS transistor Q1 is connected to a negative electrode of the transmitting terminal of the photocoupler U3; a positive electrode of the transmitting terminal of the photocoupler U3 is connected to a first terminal of the resistor R6, and a second terminal of the resistor R6 is connected to a preset voltage; and a collector of the transmitting terminal of the photocoupler U3 is connected to a second terminal of the resistor R7 to form an output terminal of the isolation unit, a first terminal of the resistor R7 is connected to a preset voltage, and an emitter of the transmitting terminal of the photocoupler U3 is grounded.

Optionally, the electronic lock detection circuit further includes:
a voltage sampling unit, connected to the electronic lock and configured to collect a voltage signal of the electronic lock.

Optionally, the electronic lock detection circuit further includes:
a voltage follower unit, located between the voltage sampling unit and the signal conversion circuit, and configured to maintain the signal of the electronic lock constant and transmit the signal of the electronic lock to the signal conversion circuit.

Optionally, an input terminal of the voltage follower unit is connected to the voltage sampling unit, and an output terminal of the voltage follower unit is connected to the signal conversion circuit; and
the voltage follower unit includes an operational amplifier U1, a non-inverting input terminal of the operational amplifier U1 is the input terminal of the voltage follower unit, an inverting input terminal of the operational amplifier U1 is connected to an output terminal of the operational amplifier U1, and the output terminal of the operational amplifier U1 is the output terminal of the voltage follower unit.

Optionally, the first switch is located between a power terminal and the electronic lock; or
the first switch is located between the electronic lock and the signal conversion circuit.

A second aspect of the embodiment of this application provides a charging pile, including the electronic lock detection circuit according to the first aspect and a processor, wherein the processor is connected to a signal conversion circuit.

A third aspect of the embodiment of this application provides a vehicle, including the electronic lock detection circuit according to the first aspect and a processor, wherein the processor is connected to a signal conversion circuit.

Technical effects of this application embodiment are as follows. The electronic lock feedback switch in the conventional technologies is replaced with the electronic lock detection circuit, and after the voltage signal generated by the electronic lock is converted and processed through an internal circuit, whether the electronic lock is locked or not is determined. Compared with an existing circuit, the electronic lock detection circuit has a simple structure, a small number of components, and low power consumption, so that manufacturing costs can be reduced. In addition, there is no need to energize or de-energize a coil to control the electronic lock feedback switch, so that the problem that the status of the electronic lock cannot be detected due to a failure of the electronic lock feedback switch is avoided, and reliability of electronic lock detection is improved. Furthermore, all components may be surface-mounted components, making overall volume of the circuit extremely small. The circuit can be fabricated as a thick-film module or a circuit assembly, facilitating mounting and soldering of the components.

### BRIEF DESCRIPTION OF DRAWINGS

To describe technical solutions in embodiments of this application more clearly, the following briefly introduces accompanying drawings required for describing the embodiments. Clearly, the accompanying drawings in the following description show merely some embodiments of this application, and a person of ordinary skill in the art may still derive other drawings from these accompanying drawings without creative efforts.
FIG. 1 is a diagram of a structure of a power supply device for an electronic lock according to the conventional technologies;
FIG. 2 is a diagram of a structure of an electronic lock detection circuit according to Embodiment 1 of this application;
FIG. 3 is a diagram of a structure of an electronic lock detection circuit according to Embodiment 2 of this application;
FIG. 4 is a diagram of another structure of an electronic lock detection circuit according to Embodiment 2 of this application;
FIG. 5 is a diagram of a structure of an electronic lock detection circuit according to Embodiment 3 of this application;
FIG. 6 is a circuit diagram of an electronic lock detection circuit according to Embodiment 4 of this application;
FIG. 7 is a circuit diagram of an electronic lock detection circuit according to Embodiment 5 of this application;
FIG. 8 is a circuit diagram of an electronic lock detection circuit according to Embodiment 6 of this application; and
FIG. 9 is a diagram of a structure of a charging pile according to Embodiment 7 of this application.

In the drawings: 10: electronic lock detection circuit; 40: electronic lock; 101: first switch; 102: power terminal; 103: voltage sampling unit; 104: voltage follower unit; 105: signal conversion circuit; 110: amplification unit; 120: isolation unit; 130: second switch; 200: processor.

### DESCRIPTION OF EMBODIMENTS

The following clearly and completely describes the technical solutions in the embodiments of this application with reference to the accompanying drawings in the embodiments of this application. Clearly, the described embodiments are merely a part rather than all of the embodiments of this application. All other embodiments obtained by a person of ordinary skill in the art based on the embodiments of this application without creative efforts shall fall within the scope of protection of this application.

It will be understood that this application can be implemented in different forms and should not be construed as being limited to embodiments set forth herein. On the contrary, these embodiments are provided for a more thorough and complete understanding of this application, and the scope of this application can be completely conveyed to those skilled in the art. In the accompanying drawings, dimensions and relative dimensions of the layers and regions may be exaggerated for clarity. Same reference numerals indicate same elements throughout.

It will be understood that when an element or layer is referred to as "on the...", "adjacent to the...", "connected to" or "coupled to" other elements or layers, it may be directly on, adjacent to, connected to, or coupled to other elements or layers, or there may be intervening elements or layers. On the contrary, when an element is referred to as "directly on the...", "directly adjacent to the...", "directly connected to" or "directly coupled to" other elements or layers, there is no intervening element or layer. It will be understood that while the terms first, second, third, and the like may be used to describe various elements, components, regions, layers, and/or portions, these elements, components, regions, layers, and/or portions should not be limited by these terms. These terms are used only to distinguish one element, component, region, layer, or portion from another element, component, region, layer, or portion. Accordingly, a first element, component, region, layer or portion discussed below may be represented as a second element, component, region, layer or portion without departing from the teachings of this application.

Spatial relationship terms such as "under...", "below...", "lower", "beneath...", "above...", "upper", and the like may be used herein for ease of description to describe a relationship of one element or feature shown in the figures to other elements or features. It will be understood that, in addition to orientations shown in the drawings, a spatial relationship term is intended to include different orientations of components in use and operation. For example, if the component in the accompanying drawings is flipped, an element or feature described as "below" or "beneath" or "under" other elements are then oriented "above" the other elements or features. Therefore, example terms "below..." and "under..." may include both upper and lower orientations. The component may be additionally oriented (rotated by 90 degrees or other orientations), and the spatial descriptors used herein are interpreted accordingly.

The terms used herein are intended to describe specific embodiments merely and are not intended to limit this application. As used herein, singular forms of "one", "an", and "said/the" are also intended to include plural forms, unless the context clearly indicates otherwise. It will also be understood that terms "consisting of" and/or "including", when used in this specification, confirm the existence of the described features, integers, steps, operations, elements and/or components, but do not exclude the existence or addition of one or more other features, integers, steps, operations, elements, components and/or groups. As used herein, a term "and/or" include any and all combinations of related listed items.

For the purpose of thoroughly understanding this application, a detailed structure and steps may be provided in the following description to explain the technical solutions proposed in this application. Preferred embodiments of this application are described below in detail. However, in addition to these detailed descriptions, other implementations may also be provided in this application.

Currently, an electric vehicle charging system mainly includes an alternating current charging system and a direct current charging system. In GB/T 18787.1-2015, an electric vehicle conductive charging system requires a vehicle interface to have a locking function to prevent accidental disconnection during charging. The conventional technologies have the following technical problems. As shown in FIG. 1, an electronic lock feedback switch S2 generally employs a physical switch such as a relay, resulting in relatively high cost. In addition, an electronic lock drives the electronic lock feedback switch S2 to actuate by using a coil, and the electronic lock feedback switch S2 is prone to failures such as sticking or failure to conduct, resulting in an inability to correctly detect a state of the electronic lock.

### Embodiment 1

Embodiment 1 of this application provides an electronic lock detection circuit to resolve problems of high costs and poor reliability caused by an electronic lock feedback switch used in the conventional technologies.

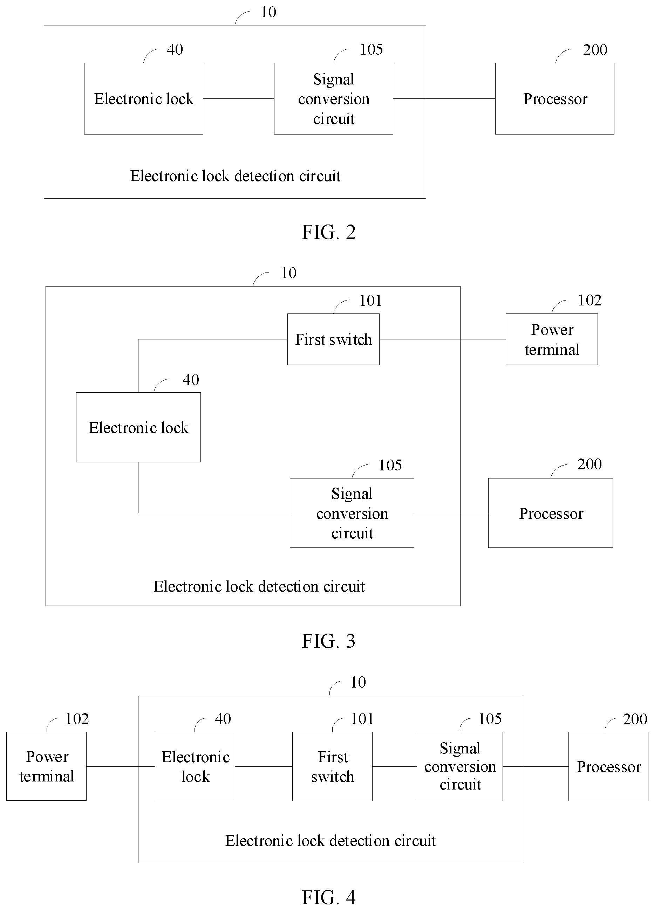

A technical solution according to Embodiment 1 of this application, as shown in FIG. 2, provides an electronic lock detection circuit 10, including:
an electronic lock 40; and
a signal conversion circuit 105, where the electronic lock 40 and the signal conversion circuit 105 are located in the same detection circuit, and the signal conversion circuit 105 is configured to convert a collected signal of the electronic lock 40 and then send a converted signal to a processor 200.

When the electronic lock detection circuit is turned on, a voltage signal or a current signal of the electronic lock 40 may be collected in a voltage or current collection method. Specifically, a state of the electronic lock 40 is obtained by configuring a sampling resistor to collect the voltage signal of the electronic lock 40.

The signal conversion circuit 105 is configured to process the collected signal of the electronic lock 40, making a processed signal suitable for detecting whether the detected electronic lock 40 is in a locked state. For a processing method: a first processing method for the signal conversion circuit 105 is to amplify and convert the collected signal of the electronic lock 40. Specifically, the circuit further amplifies a collected analog signal of the electronic lock 40 through an inverting proportional operational amplifier circuit, and an amplification factor can be adjusted by adjusting a ratio of an input resistance to a feedback resistance, making a design more flexible. A final output analog signal may be configured to detect the locked state of the electronic lock 40, thereby enabling the processor 200 to detect the state of the electronic lock 40. A second processing method for the signal conversion circuit 105 is to implement isolation of input and output signals by using an isolation component such as a photocoupler, thereby ensuring electrical isolation between the input and output signals and improving safety and reliability of the circuit. Changes in high and low levels of a signal output from an output terminal can reflect whether the electronic lock 40 is in the locked state, so that the processor 200 can monitor the status of the electronic lock 40. A third processing method of the signal conversion circuit 105, which combines the first processing method and the second processing method, is to first further amplify a collected analog signal of the electronic lock 40, and then output the collected analog signal after isolation, thereby enabling the processor 200 to monitor of the status of the electronic lock 40.

Technical effects of Embodiment 1 of this application are as follows. An electronic lock feedback switch in the conventional technologies is replaced with the electronic lock detection circuit, and after the voltage signal generated by the electronic lock is converted and processed through an internal circuit, whether the electronic lock is locked or not is determined. Compared with an existing circuit, the electronic lock detection circuit has a simple structure, a small number of components, and low power consumption, so that manufacturing costs can be reduced. In addition, there is no need to energize or de-energize a coil to control the electronic lock feedback switch, so that the problem that the status of the electronic lock cannot be detected due to a failure of the electronic lock feedback switch is avoided, and reliability of electronic lock detection is improved. Furthermore, all components may be surface-mounted components, making overall volume of the circuit extremely small. The circuit can be fabricated as a thick-film module or a circuit assembly, facilitating mounting and soldering of the components.

### Embodiment 2

Embodiment 2 of this application provides an electronic lock detection circuit. A first switch is disposed in the electronic lock detection circuit, and energization and de-energization of an electronic lock are achieved by controlling the first switch.

A technical solution according to Embodiment 2 of this application is based on the technical solution according to Embodiment 1, as shown in FIG. 3 and FIG. 4, the electronic lock detection circuit further includes a first switch 101, where a power terminal 102, the first switch 101, an electronic lock 40, and a signal conversion circuit 105 form a detection loop.

When the first switch 101 is turned on, the electronic lock detection loop is turned on to provide power for the electronic lock 40, so that the electronic lock 40 can operate normally. When the first switch 101 is turned off, the electronic lock detection loop is disconnected, and the power terminal 102 stops supplying power to the electronic lock 40, so that the electronic lock 40 is de-energized and stops operating.

For a connection method of the first switch, as an implementation, as shown in FIG. 3, the first switch 101 is located between the power terminal 102 and the electronic lock 40.

For a connection method of the first switch, as another implementation, as shown in FIG. 4, the first switch 101 is located between the electronic lock 40 and the signal conversion circuit 105.

Technical effects of configuring the first switch in Embodiment 2 are as follows. The configuring of the first switch enables convenient control of energization and de-energization of the electronic lock, so that the electronic lock can be controlled. This provides a more flexible electronic lock application method while improving safety.

### Embodiment 3

Embodiment 3 of this application provides an electronic lock detection circuit. A voltage follower unit is disposed in the electronic lock detection circuit to improve quality of a transmitted voltage signal.

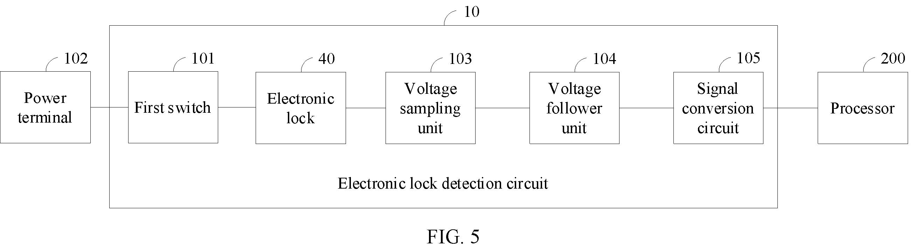

A technical solution according to Embodiment 3 of this application is based on the technical solution according to Embodiment 1, as shown in FIG. 5, the electronic lock detection circuit 10 further includes:
a voltage sampling unit 103, connected to an electronic lock 40 and configured to collect a voltage signal of the electronic lock 40.

The voltage sampling unit 103 may be a voltage collection component such as a sampling resistor.

The electronic lock detection circuit 10 further includes:
a voltage follower unit 104, located between the voltage sampling unit 103 and a signal conversion circuit 105 for maintaining the voltage signal of the electronic lock 40 constant and transmitting the voltage signal of the electronic lock 40.

The voltage follower unit 104 is configured to maintain a voltage constant during signal transmission in a circuit and increase an input resistance and reduce a loss of an input signal voltage, thereby improving signal quality and a signal-to-noise ratio. The input signal is tracked in real time, reproduced and proportionally amplified for output, such that a voltage proportional relationship between the output signal and an input signal remains constant, achieving the purpose of signal transmission.

As a preferred implementation, as shown in FIG. 5, the power terminal 102, the first switch 101, the electronic lock 40, the voltage sampling unit 103, the voltage follower unit 104, and the signal conversion circuit 105 form a detection loop.

Technical effects of configuring the voltage follower unit in Embodiment 3 are as follows. The voltage follower unit plays a voltage stabilizing role in the circuit, so that the voltage signal of the electronic lock remains constant during transmission, it can be ensured that the voltage signal received by the electronic lock is stable and is not affected by external interference or a circuit change, and stable operation of the electronic lock is guaranteed. During signal transmission, there is a possibility of signal voltage loss. The voltage follower unit can effectively reduce the signal voltage loss to ensure accuracy and integrity of the signal when transmitted in the circuit. The voltage follower unit maintains stability of the signal and reduces the signal voltage loss, thereby improving signal quality and a signal-to-noise ratio.

### Embodiment 4

Embodiment 4 of this application provides an electronic lock detection circuit, and a voltage detection signal is output after a voltage signal of an electronic lock is amplified by a signal conversion circuit.

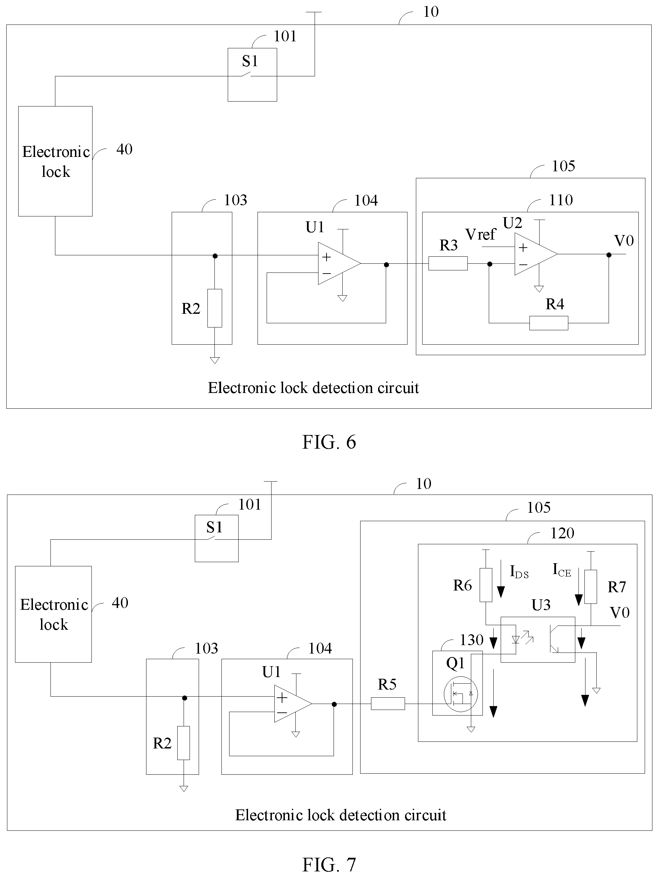

A technical solution according to Embodiment 4 of this application is based on the technical solution according to Embodiment 1, as shown in FIG. 6, a voltage sampling unit 103 includes a sampling resistor R2, a first terminal of the sampling resistor R2 is connected to an electronic lock 40, and a second terminal of the sampling resistor R2 is grounded.

A voltage follower unit 104 includes an operational amplifier U1, a non-inverting input terminal of the operational amplifier U1 is connected to the first terminal of the sampling resistor R2, and an inverting input terminal of the operational amplifier U1 is connected to an output terminal of the operational amplifier U1.

A signal conversion circuit 105 is configured to amplify a voltage signal of the electronic lock 40 and output an amplified voltage signal. An input terminal of the signal conversion circuit 105 is connected to an output terminal of the voltage follower unit 104. The signal conversion circuit 105 includes an amplification unit 110, where the amplification unit 110 is configured to amplify a collected signal of the electronic lock 40 and then send an amplified signal to a processor 200. The amplification unit 110 includes a resistor R3, a resistor R4, and an operational amplifier U2. A first terminal of the resistor R3 is the input terminal of the signal conversion circuit 105, a second terminal of the resistor R3 is connected to an inverting input terminal of the operational amplifier U2 and a first terminal of the resistor R4, a second terminal of the resistor R4 is connected to an output terminal of the operational amplifier U2, and a non-inverting input terminal of the operational amplifier U2 is connected to a reference bias voltage.

When a switch S1 is closed, the switch S1, the electronic lock 40, the voltage sampling unit 103, the voltage follower unit 104, and the signal conversion circuit 105 form a loop, and the sampling resistor R2 obtains a voltage signal of the electronic lock 40 through voltage division sampling in the loop.

The voltage follower unit 104 employs the operational amplifier U1 to amplify a voltage of the voltage signal of the electronic lock 40 and follow a change in the amplified voltage, thereby outputting a signal of the same magnitude but with a voltage gain of 1. The voltage follower unit 104 can effectively increase an input resistance of the signal, reduce a voltage loss of an input signal, and improve a signal-to-noise ratio.

The signal conversion circuit 105 is an inverting proportional operational amplifier circuit composed of a second operational amplifier U2, and voltages of the resistor R3 and the resistor R4. The non-inverting input terminal of the second operational amplifier U2 is connected to a Vref reference bias voltage. High open-loop characteristics caused by virtual short and virtual open of the second operational amplifier U2 are utilized to amplify an input signal of the inverting proportional operational amplifier circuit, thereby outputting analog quantity Vo. Controlling closing or opening of the switch S1 can detect a change in an analog value at a Vo terminal, thereby determining whether the electronic lock 40 is in the locked state. The resistor R3 and the resistor R4 can be used to properly adjust an amplification ratio of the input signal as required and then output an analog quantity Vo with a suitable ratio.

Technical effects of Embodiment 4 are as follows. The signal conversion circuit employs the inverting proportional operational amplifier circuit of the operational amplifier, which can provide high-precision signal amplification and conversion and ensure accuracy and stability of an output signal. The signal conversion circuit employs virtual short and virtual open characteristics of the operational amplifier, which can effectively reduce nonlinear distortion, temperature drift, and other effects of the circuit, thereby improving performance of the circuit. After the input signal of the signal conversion circuit is amplified, an output analog signal can reflect a change in the input signal sensitively, so that the locking state of the electronic lock can be accurately detected. The resistor R3 and the resistor R4 of the signal conversion circuit can properly adjusted as required to change an amplification ratio of the input signal, making design selection more flexible.

### Embodiment 5

Embodiment 5 of this application provides an electronic lock detection circuit, and a voltage detection signal is output after a voltage signal of an electronic lock is isolated by a signal conversion circuit.

A technical solution according to Embodiment 5 of this application is based on the technical solution according to Embodiment 1, as shown in FIG. 7, a signal conversion circuit 105 is configured to isolate a voltage signal of an electronic lock 40 and output an isolated voltage signal. An input terminal of the signal conversion circuit 105 is connected to an output terminal of a voltage follower unit 104.

The signal conversion circuit 105 includes an isolation unit 120, and the isolation unit 120 is configured to isolate a collected signal of the electronic lock 40 and then send an isolated signal to a processor 200. The isolation unit 120 includes a resistor R6, a resistor R7, a second switch 130, and a photocoupler U3. The resistor R6, the second switch 130, and a transmitting terminal of the photocoupler U3 form a first series branch, the resistor R7 and a receiving terminal of the photocoupler U3 form a second series branch, and a control terminal of the second switch 130 is the input terminal of the signal conversion circuit.

The second switch 130 may be a switch transistor, and the switch transistor may be located at a positive terminal of the transmitting terminal of the photocoupler U3, or may be located at a negative terminal of the transmitting terminal of the photocoupler U3.

As an implementation, the second switch 130 may be an NMOS transistor Q1, the signal conversion circuit 105 includes a resistor R5, a resistor R6, a resistor R7, an NMOS transistor Q1, and a photocoupler U3. A first terminal of a resistor R3 is an input terminal of the signal conversion circuit 105, a second terminal of the resistor R3 is connected to a gate of the NMOS transistor Q1, a source of the NMOS transistor Q1 is grounded, a drain of the NMOS transistor Q1 is connected to a negative electrode of the transmitting terminal of the photocoupler U3, a positive electrode of the transmitting terminal of the photocoupler U3 is connected to a first terminal of the resistor R6, and a second terminal of the resistor R6 is connected to a power terminal 102, a collector of the transmitting terminal of the photocoupler U3 is connected to a second terminal of the resistor R7 to form an output terminal of the signal conversion circuit 105, a first terminal of the resistor R7 is connected to the power terminal 102, and an emitter of the transmitting terminal of the photocoupler U3 is grounded.

The resistor R6, the transmitting terminal of the photocoupler U3, and the NMOS transistor Q1 form an I_{DS} loop, and the resistor R7 and the receiving terminal of the photocoupler U3 form an I_{CE} loop. The resistor R6 is a current-limiting resistor of the I_{DS} loop, which is configured to prevent the photocoupler U3 and the NMOS transistor Q1 from being damaged by overcurrent. The collector of the receiving terminal of the photocoupler U3, one terminal of the resistor R7, and a Vo signal output terminal are connected, and the resistor R7 is a pull-up resistor. When the photocoupler U3 is turned off, the Vo signal output terminal is clamped to a high level by using the resistor R7. When the photocoupler U3 is turned on, a low level is generated at the Vo signal output terminal, and the resistor R7 plays a current-limiting role in the I_{CE} loop. Opening or closing of the first switch S1 is controlled to detect a level change at the Vo signal output terminal, thereby determining whether the electronic lock 40 is in the locked state. As the photocoupler U3 transmits an electrical signal with light as a medium, the photocoupler U3 has a good isolation effect on input and output electrical signals. Therefore, effective electrical isolation can be achieved between the signal conversion circuit 105 and the processor 200, making design selection more flexible.

Technical effects of Embodiment 5 of this application are as follows. As the photocoupler in the signal conversion circuit is a medium for signal isolation, the input and output signals can be effectively isolated to protect the processor and the detection circuit and improve reliability of the system. A current-limiting resistor R6 is configured to protect the photocoupler U3 and the NMOS transistor Q1 to prevent a component from being damaged by overcurrent, thereby enhancing reliability and stability of the circuit.

### Embodiment 6

Embodiment 6 of this application provides an electronic lock detection circuit, and a voltage detection signal is output after a voltage signal of an electronic lock is amplified and isolated by a signal conversion circuit.

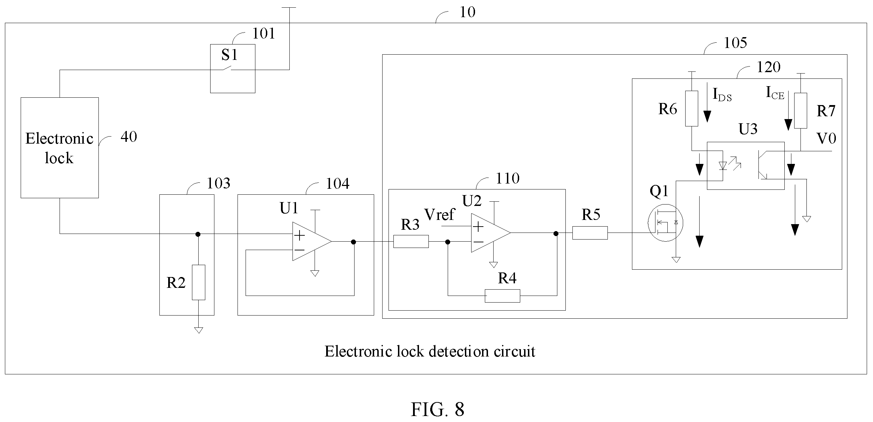

A technical solution according to Embodiment 6 of this application is based on the technical solution according to Embodiment 1, as shown in FIG. 8, a signal conversion circuit 105 is configured to amplify and isolate a voltage signal of an electronic lock 40 and output an amplified and isolated voltage signal. An input terminal of the signal conversion circuit 105 is connected to an output terminal of a voltage follower unit 104.

The signal conversion circuit 105 includes an amplification unit 110 and an isolation unit 120. The amplification unit 110 is configured to amplify a collected signal of the electronic lock 40, and the isolation unit 120 is configured to isolate an amplified signal and then send an isolated amplified signal to a processor 200. The amplification unit 110 includes a resistor R3, a resistor R4, and an operational amplifier U2. The isolation unit 120 includes a resistor R6, a resistor R7, an NMOS transistor Q1, and a photocoupler U3. The signal conversion circuit 105 further includes a resistor R5. A first terminal of the resistor R3 is an input terminal of the signal conversion circuit 105, a second terminal of the resistor R3 is connected to an inverting input terminal of the operational amplifier U2 and a first terminal of the resistor R4, and a second terminal of the resistor R4 is connected to an output terminal of the operational amplifier U2. A non-inverting input terminal of the operational amplifier U2 is connected to a reference bias voltage, the first terminal of the resistor R3 is connected to the output terminal of the operational amplifier U2, the second terminal of the resistor R3 is connected to a gate of the NMOS transistor Q1, a source of the NMOS transistor Q1 is grounded, a drain of the NMOS transistor Q1 is connected to a negative electrode of a transmitting terminal of the photocoupler U3, a positive electrode of the transmitting terminal of the photocoupler U3 is connected to a first terminal of the resistor R6, and a second terminal of the resistor R6 is connected to a power terminal 102. A collector of the transmitting terminal of the photocoupler U3 is connected to a second terminal of the resistor R7 to form an output terminal of the signal conversion circuit 105, a first terminal of the resistor R7 is connected to the power terminal 102, and an emitter of the transmitting terminal of the photocoupler U3 is grounded.

The voltage signal of the electronic lock 40 enters an inverting proportional operational amplifier circuit composed of a second operational amplifier U2, the resistor R3, and the resistor R4, and is amplified proportionally. The amplified signal enters the photocoupler U3, and when the photocoupler U3 is turned off, a Vo signal output terminal is clamped to a high level by the resistor R7. When the photocoupler U3 is turned on, a low level is generated at the Vo signal output terminal. As the photocoupler transmits an electrical signal with light as a medium, input and output signals can be effectively isolated to avoid mutual interference. The processor 200 can detect a level change of the Vo terminal by controlling a switch S1 to be closed or opened, thereby determining whether the electronic lock 40 is in the locked state.

Technical effects of Embodiment 6 of this application are as follows. The inverting proportional operational amplifier circuit is used for amplification and conversion of the voltage signal, an amplitude of the input signal can be amplified to an appropriate range for subsequent processing and detection. As the photocoupler serves as a transmission medium for the input and output signals, the input and output electrical signals can be effectively isolated to avoid mutual interference between the input and the output, thereby improving reliability and stability of the system. The inverting proportional operational amplifier circuit composed of adjustable resistors is adopted, which can flexibly adjust an amplification ratio of the input signal as required and then output an analog signal with a suitable ratio. In addition, the locking state of the electronic lock can be detected by using the switch for control. The current-limiting resistor is used in the I_{DS} loop to prevent the photocoupler and NMOS transistor from being damaged by overcurrent. In addition, the pull-up resistor and the current-limiting resistor are used in the I_{CE} loop to effectively protect stability and reliability of the system.

### Embodiment 7

Embodiment 7 of this application provides a charging pile, including an electronic lock detection circuit provided in Embodiment 1 to Embodiment 6, as well as a processor, where the processor is connected to a signal conversion circuit.

In a technical solution according to Embodiment 7 of this application, when the electronic lock detection circuit is disposed in the charging pile, for example, when the electronic lock detection circuit is disposed in a charging gun or a charging pile body, a state of an electronic lock can be detected during direct current charging of a vehicle.

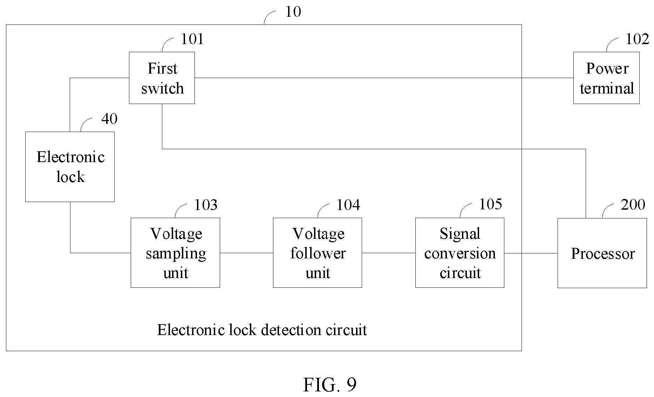

The technical solution according to Embodiment 7 of this application is based on the technical solution according to Embodiment 1, as shown in FIG. 9, the charging pile further includes:
a processor 200, having an input terminal connected to an output terminal of the signal conversion circuit 105 and an output terminal connected to a control terminal of a first switch 101, where the processor 200 is configured to detect a locking state of an electronic lock 40 through a voltage detection signal upon controlling the first switch 101 to be turned on or off.

The processor 200 is connected to a control terminal of the switch 101 via the output terminal thereof, and can control the first switch 101 to be turned on or off. When the processor 200 controls the first switch 101 to be turned on or off, if a level change is detected at the output terminal of the signal conversion circuit 105, the locking state of the electronic lock 40 can be determined. If the first switch 101 is controlled to be turned on, and a signal from the output terminal of the signal conversion circuit 105 is detected to be at a high level, the electronic lock 40 is determined to be in a locked state. If the first switch 101 is controlled to be turned off, the signal from the output terminal of the signal conversion circuit 105 is detected to be at a low level, the electronic lock 40 is determined to be in an unlocked state. The first switch 101 is controlled to be turned on or off, so that the processor can effectively control a state of the electronic lock 40 and detect the signal from the output terminal of the signal conversion circuit 105 in real time to obtain the state of the electronic lock 40, implementing management and control of the electronic lock 40.

Technical effects of Embodiment 7 are as follows. The processor is disposed in the charging pile to control the switch to be turned on or off, so that an on/off state of the electronic lock can be remotely controlled, and the signal conversion circuit can detect the locking state of the electronic lock in real time to obtain a usage situation of the electronic lock at any time, thereby enhancing management and security of the electronic lock.

### Embodiment 8

Embodiment 8 of this application provides a vehicle, including an electronic lock circuit provided in Embodiment 1 to Embodiment 6, as well as a processor, where the processor is connected to a signal conversion circuit.

In a technical solution according to Embodiment 8 of this application, when an electronic lock detection circuit is disposed in a vehicle, for example, disposed at a charging port, a state of an electronic lock can be detected during alternating current charging of the vehicle.

The foregoing embodiments are merely used to describe the technical solutions of this application, rather than limitation. Although this application is described in detail with reference to the foregoing embodiments, a person of ordinary skill in the art should understand that: the technical solutions described in the foregoing embodiments may still be modified, or some technical features thereof may be equivalently replaced. These modifications or replacements shall not cause essential nature of the corresponding technical solutions to deviate from the spirit and scope of the technical solutions in the embodiments of this application, and shall be encompassed within the scope of protection of this application.

## Claims

1. An electronic lock detection circuit (10), comprising:
an electronic lock (40); and
a signal conversion circuit (105), the electronic lock (40) and the signal conversion circuit (105) being located in a same detection circuit, and the signal conversion circuit (105) being configured to convert a collected signal of the electronic lock (40) and then send a converted signal to a processor (200).

2. The electronic lock detection circuit according to claim 1, wherein the signal conversion circuit (105) comprises an amplification unit (110), and the amplification unit (110) is configured to amplify the collected signal of the electronic lock (40) and then send an amplified signal to the processor (200).

3. The electronic lock detection circuit according to claim 1, wherein the signal conversion circuit (105) comprises an isolation unit (120), and the isolation unit (120) is configured to isolate the collected signal of the electronic lock (40) and then send an isolated signal to the processor (200).

4. The electronic lock detection circuit according to claim 1, wherein the signal conversion circuit (105) comprises an amplification unit (110) and an isolation unit (120), the amplification unit (110) is configured to amplify the collected signal of the electronic lock (40), and the isolation unit (120) is configured to isolate an amplified signal and then send an isolated amplified signal to the processor (200).

5. The electronic lock detection circuit according to claim 2 or 4, wherein the amplification unit (110) comprises a resistor R3, a resistor R4, and an operational amplifier U2, a first terminal of the resistor R3 is an input terminal of the signal conversion circuit, a second terminal of the resistor R3 is connected to an inverting input terminal of the operational amplifier U2 and a first terminal of the resistor R4, a second terminal of the resistor R4 is connected to an output terminal of the operational amplifier U2, a non-inverting input terminal of the operational amplifier U2 is connected to a reference bias voltage, and the output terminal of the operational amplifier U2 is an output terminal of the amplification unit (110).

6. The electronic lock detection circuit according to claim 3 or 4, wherein the isolation unit (120) comprises a resistor R6, a resistor R7, a second switch (130), and a photocoupler U3; the resistor R6, the second switch (130), and a transmitting terminal of the photocoupler U3 form a first series branch; the resistor R7 and a receiving terminal of the photocoupler U3 form a second series branch; and a control terminal of the second switch (130) is an input terminal of the isolation unit (120).

7. The electronic lock detection circuit according to claim 6, wherein the second switch (130) is an NMOS (N-Metal-Oxide-Semiconductor) transistor Q1; a gate of the NMOS transistor Q1 is the control terminal of the second switch (130), a source of the NMOS transistor Q1 is grounded, and a drain of the NMOS transistor Q1 is connected to a negative electrode of the transmitting terminal of the photocoupler U3; a positive electrode of the transmitting terminal of the photocoupler U3 is connected to a first terminal of the resistor R6, and a second terminal of the resistor R6 is connected to a preset voltage; and a collector of the transmitting terminal of the photocoupler U3 is connected to a second terminal of the resistor R7 to form an output terminal of the isolation unit, a first terminal of the resistor R7 is connected to a preset voltage, and an emitter of the transmitting terminal of the photocoupler U3 is grounded.

8. The electronic lock detection circuit according to any one of claims 1 to 7, wherein the electronic lock detection circuit (10) further comprises:
a voltage sampling unit (103), connected to the electronic lock (40) and configured to collect a voltage signal of the electronic lock (40).

9. The electronic lock detection circuit according to any one of claims 1 to 8, wherein the electronic lock detection circuit (10) further comprises:
a voltage follower unit (104), located between the voltage sampling unit (103) and the signal conversion circuit (105), and configured to maintain the signal of the electronic lock (40) constant and transmit the signal of the electronic lock (40) to the signal conversion circuit (105).

10. The electronic lock detection circuit according to claim 9, wherein an input terminal of the voltage follower unit (130) is connected to the voltage sampling unit (103), and an output terminal of the voltage follower unit (104) is connected to the signal conversion circuit (105); and
the voltage follower unit (130) comprises an operational amplifier U1, a non-inverting input terminal of the operational amplifier U1 is the input terminal of the voltage follower unit, an inverting input terminal of the operational amplifier U1 is connected to an output terminal of the operational amplifier U1, and the output terminal of the operational amplifier U1 is the output terminal of the voltage follower unit (130).

11. The electronic lock detection circuit according to any one of claims 1 to 10, wherein a first switch (101) is located between a power terminal (102) and the electronic lock (40); or
the first switch (101) is located between the electronic lock (40) and the signal conversion circuit (105).

12. A charging pile, comprising the electronic lock detection circuit (10) according to any one of claims 1 to 11 and a processor (200), and the processor (200) being connected to a signal conversion circuit (105).

13. A vehicle, comprising the electronic lock detection circuit (10) according to any one of claims 1 to 11 and a processor (200), and the processor (200) being connected to a signal conversion circuit (105).
